# EUROPÄISCHE PATENTSCHRIFT

(11) **EP 2 338 184 B1**
(45) Veröffentlichungstag und Bekanntmachung des Hinweises auf die Patenterteilung: **03.07.2013**
(21) Anmeldenummer: 09784031.8
(22) Anmeldetag: 15.10.2009
(51) Int. Cl.: H01L 41/053, H01L 41/22

(54) **VERFAHREN UND VORRICHTUNG ZUR HERSTELLUNG EINES PIEZOKÖRPERS**
METHOD AND DEVICE FOR PRODUCING A PIEZOELECTRIC MEMBER
PROCÉDÉ ET DISPOSITIF POUR PRODUIRE UN CORPS PIÉZOÉLECTRIQUE

(30) Priorität: 16.10.2008 DE 102008051932
(43) Veröffentlichungstag der Anmeldung: 29.06.2011
(73) Patentinhaber: Continental Automotive GmbH, 30165 Hannover (DE)
(72) Erfinder: HAMANN, Christoph, 93107 Thalmassing (DE); LIXL, Heinz, 93053 Regensburg (DE)
(86) Internationale Anmeldenummer: PCT/EP2009/063493
(87) Internationale Veröffentlichungsnummer: WO 2010/043677

(56) Entgegenhaltungen:
- EP-A- 2 086 029
- DE-A1-102005 035 158
- DE-A1-102006 000 024
- US-A- 5 148 077

## Beschreibung

Die Erfindung betrifft ein Verfahren und eine Vorrichtung zur Herstellung eines Piezokörpers.

Aus der WO 00/08353 ist ein Piezokörper bekannt mit einem Stapel piezoelektrischer Elemente, mit zwei Kontaktstiften, die durch die Oberfläche des Piezokörpers hindurchgeführt sind. Ferner ist in der WO 00/08353 auch ein Piezoaktuator offenbart, der neben dem Piezokörper eine Rohrfeder umfasst, in die der Piezokörper eingebracht ist und an deren freien Enden Kappen angeschweißt sind, wodurch der Piezokörper mit einer vorgegebenen Vorspannung vorgespannt wird. Die Kontaktstifte sind elektrisch leitend mit den einzelnen Elementen des Piezostapels verbunden. Wenn eine Spannungsdifferenz an den Kontaktstiften angelegt wird, verändert sich die axiale Ausdehnung des Stapels der Piezoelemente. Aus der WO 00/08353 ist es ferner bekannt, den Piezoaktuator in einem Fluidinjektor anzuordnen.

Piezokörper oder auch Piezoaktuatoren haben den Vorteil einer sehr schnellen Reaktionszeit auf Stellsignale und sind so insbesondere für den Einsatz bei Fluidinjektoren, insbesondere im Kraftfahrzeugbereich sehr gut geeignet und ermöglichen so mehrfache Einspritzungen von Kraftstoff in einen Zylinder einer Brennkraftmaschine während eines Arbeitszyklus eines Zylinders der Brennkraftmaschine.

Für einen zuverlässigen Betrieb des Piezokörpers, des Piezoaktuators und des Fluidinjektors muss sichergestellt sein, dass elektrische Kurzschlüsse vermieden werden.

Das US Patent 5 148 077 offenbart ein Verfahren zur Beschichtung eines Piezokörpers, bei welchem zunächst ein Haftvermittler und ein erstes Silikonelastomer und anschließend ein zweites Silikonelastomer aufgetragen werden. Zwischen dem ersten und dem zweiten Silikonelastomere wird eine Zwischenschicht aufgetragen, um Reibung zwischen der ersten Silikonschicht und der umhüllenden Silikonschicht zu reduzieren.

Die Aufgabe der Erfindung ist es, ein Verfahren und eine Vorrichtung zur Herstellung eines Piezokörpers zu schaffen, der über eine lange Betriebsdauer einen zuverlässigen Betrieb des Piezokörpers ermöglicht.

Die Aufgabe wird gelöst durch die Merkmale der unabhängigen Patentansprüche. Vorteilhafte Weiterbildungen der Erfindung sind in den Unteransprüchen gekennzeichnet.

Die Erfindung, zeichnet sich aus durch ein Verfahren und eine Vorrichtung zur Herstellung eines Piezokörpers, wobei der Piezokörper einen Stapel piezoelektrischer Elemente aufweist. In einem ersten Schritt wird ein erstes Silikon mit einem Haftvermittler auf den Stapel piezoelektrischer Elemente zum Herstellen einer Isolierschicht aufgesprüht, und ein weiteres Silikon wird mittels Spritzgießen aufgebracht zum Herstellen eines Umhüllungselements, das zum Umhüllen mindestens eines Teils des Stapels piezoelektrischer Elemente ausgebildet ist.

Das Aufsprühen des ersten Silikons mit dem Haftvermittler und das Spritzgießen des weiteren Silikons können unmittelbar aufeinander folgen. Zwischen dem Aufsprühen des ersten Silikons mit dem Haftvermittler und dem Spritzgießen des weiteren Silikons können auch weitere geeignete Verfahrensschritte durchgeführt werden.

Das Verfahren hat den Vorteil, dass durch Aufsprühen des ersten Silikons mit dem Haftvermittler und Spritzgießen des weiteren Silikons eine nachträgliche Reinigung von Stirnflächen des Stapels piezoelektrischer Elemente von Silikon vermieden werden kann und eine Automatisierung des Verfahrens zur Herstellung des Piezokörpers ermöglicht ist. Die Haftfestigkeit der Isolierschicht und des Umhüllungselements an dem Stapel piezoelektrischer Elemente kann sehr gut sichergestellt werden. Des Weiteren können in der Isolierschicht und dem Umhüllungselement Kontaktdrähte zum Herstellen elektrischer Verbindungen zu den piezoelektrischen Elementen eingebettet sein. Dies ermöglicht eine mechanisch sichere Fixierung der Kontaktdrähte. Des Weiteren ermöglicht die Isolierschicht und das Umhüllungselement eine elektrische Isolation des Piezokörpers gegenüber einem Gehäuse zur Aufnahme des Piezokörpers.

In einer vorteilhaften Ausgestaltung der Erfindung wird nach dem Herstellen der Isolierschicht und vor dem Aufbringen des weiteren Silikons ein Silikon ohne Haftvermittler auf die Isolierschicht aufgesprüht zum Herstellen einer Zwischenschicht. Dies hat den Vorteil, dass die Zwischenschicht ohne Haftvermittler auch das Einwirken von großen Kräften zwischen der Isolierschicht und dem Umhüllungselement ermöglicht, ohne dass die mechanische Kopplung zwischen der Isolierschicht und dem Umhüllungselement verloren geht. Dies gilt insbesondere für Scherkräfte zwischen der Isolierschicht und dem Umhüllungselement.

In einer weiteren vorteilhaften Ausgestaltung der Erfindung wird vor dem Aufbringen des ersten Silikons mit einem Haftvermittler auf den Stapel piezoelektrischer Elemente der Stapel piezoelektrischer Elemente erhitzt. Dies hat den Vorteil, dass ein rasches Vernetzen der Isolierschicht und gegebenenfalls der Zwischenschicht möglich ist. Dies erlaubt im Anschluss ein rasches Aufbringen des weiteren Silikons.

In einer weiteren vorteilhaften Ausgestaltung der Erfindung führt der Stapel piezoelektrischer Elemente während des Aufbringens des ersten Silikons und/oder des Silikons ohne Haftvermittler eine Rotationsbewegung aus. Damit ist eine gleichmäßige Ausbildung der Isolierschicht und/oder der Zwischenschicht auf einer Mantelfläche des Stapels piezoelektrischer Elemente möglich.

Ausführungsbeispiele der Erfindung sind im Folgenden anhand der schematischen Zeichnungen erläutert. Es zeigen:
- Figur 1: einen Fluidinjektor,
- Figur 2: einen Piezoaktuator mit einem Piezokörper,
- Figur 3: einen Teilbereich des Piezokörpers, und
- Figur 4: ein Diagramm zum Verfahren zur Herstellung des Piezokörpers.

Elemente gleicher Konstruktion oder Funktion sind figuren-übergreifend mit den gleichen Bezugszeichen gekennzeichnet.

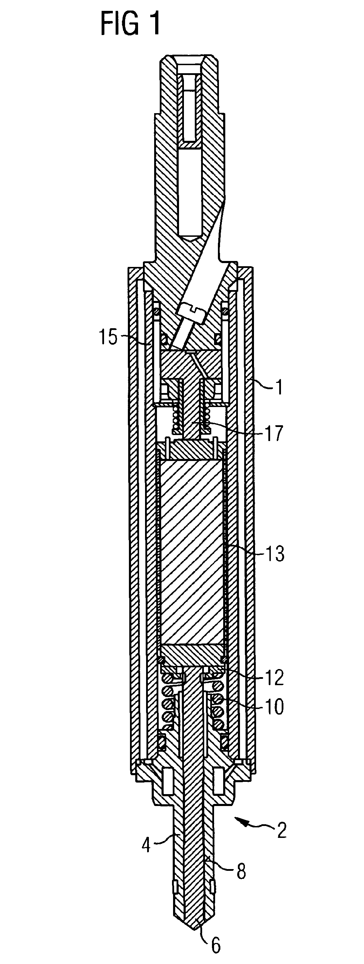

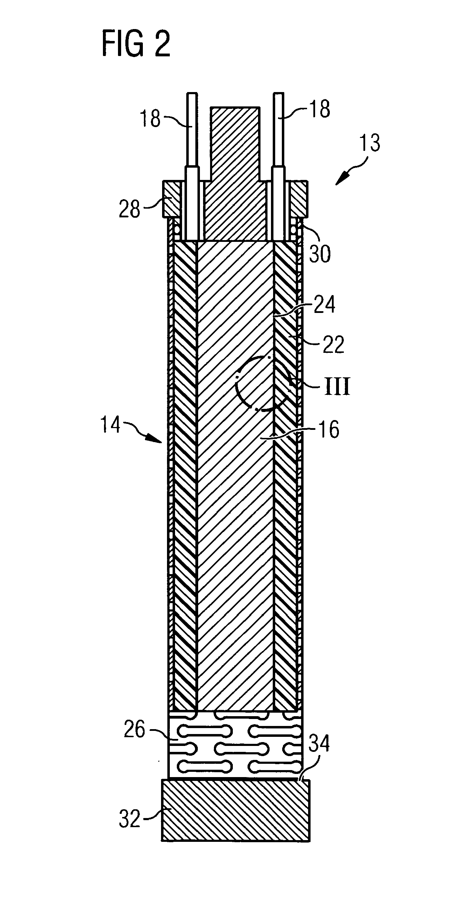

In Figur 1 ist ein Fluidinjektor gezeigt, der bevorzugt ausgebildet ist als ein Kraftstoffinjektor und der geeignet ist zum Einspritzen von Kraftstoff in eine Brennkraftmaschine. Der Fluidinjektor umfasst ein Gehäuse 1, einen Ventilkörper 2 und einen Piezoaktuator 13 mit einem Piezokörper 14 (Figur 2). Ist der Fluidinjektor als Kraftstoffinjektor ausgebildet, so ist er bevorzugt in einem Zylinderkopf der Brennkraftmaschine angeordnet und misst Kraftstoff in einen Verbrennungsraum eines Zylinders der Brennkraftmaschine zu. Das Gehäuse 1 des Fluidinjektors kann doppelrohrförmig ausgebildet sein. In dem Zwischenraum zwischen den Wänden dieser Doppelrohre kann dann das Fluid hin zu dem Ventilkörper 2 geführt werden.

Der Ventilkörper 2 umfasst ein Ventilkörpergehäuse 4 mit einer Ausnehmung und einer Nadel 6, die in die Ausnehmung des Ventilkörpergehäuses 4 eingesetzt ist und im Bereich einer Führung 8 in dem Ventilkörpergehäuse 4 geführt ist. Abhängig von der Position der Nadel 6 fließt Kraftstoff durch eine Einspritzdüse, die zwischen einem Bereich der Spitze der Nadel 6 und des Ventilkörpergehäuses gebildet wird. Bevorzugt ist die Nadel 6 nach außen öffnend ausgebildet. Sie kann jedoch auch nach innen öffnend ausgebildet sein. Die Nadel 6 wird durch eine Rückstellfeder 10 in ihre Schließposition vorgespannt. Die Rückstellfeder 10 stützt sich auf einem Federteller 12 ab, der mit der Nadel 6 verbunden ist. Die Rückstellfeder 10 übt in der Schließrichtung eine Kraft auf die Nadel 6 aus.

Der Piezoaktuator 13 ist in ein inneres Rohr 15 des Gehäuses 1 eingesetzt. Der Piezoaktuator 13 wird im Bereich seines axialen Endes von einem thermischen Ausgleichselement 17 kontaktiert. An seinem anderen axialen Ende ist er mit der Nadel 8 derart verbunden, dass er mit dieser zusammenwirken kann.

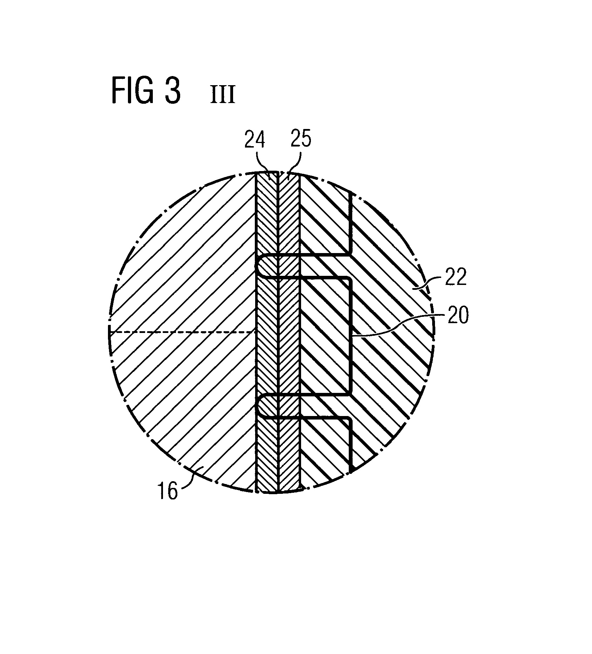

Der Piezokörper 14 umfasst einen Stapel 16 mit einer Vielzahl an piezoelektrischen Elementen (Figur 2). Ferner umfasst der Piezokörper 14 zwei Kontaktstifte 18, die über Kontaktdrähte 20 (Figur 3) mit den einzelnen piezoelektrischen Elementen elektrisch leitend verbunden sind. Die Kontaktdrähte 20 haben in der hier gezeigten Ausführungsform eine mäanderförmige Struktur, um so eine besonders gute Langzeitstabilität der elektrischen Anschlüsse für die Piezoelemente zu gewährleisten. In weiteren Ausführungsformen haben die Kontaktdrähte 20 eine kammförmige Struktur.

Der Stapel 16 piezoelektrischer Elemente ist entlang seiner axialen Ausdehnung von einem Umhüllungselement 22 umgeben, das bevorzugt aus einem Silikon besteht. Das Umhüllungselement 22 umschließt auch die Kontaktstifte 18 und die Kontaktdrähte 20 entlang der axialen Ausdehnung des Stapels 16 piezoelektrischer Elemente. Das Umhüllungselement 22 bildet ein Isoliermedium. Zwischen dem Stapel 16 piezoelektrischer Elemente und dem Umhüllungselement 22 ist anliegend an den Stapel 16 piezoelektrischer Elemente eine Isolierschicht 24 angeordnet. In der in Figur 3 gezeigten Ausführungsform ist zwischen der Isolierschicht 24 und dem Umhüllungselement 22 eine Zwischenschicht 25 angeordnet, deren Bedeutung im Folgenden noch erläutert wird. In weiteren Ausführungsformen liegt die Isolierschicht 24 direkt an dem Umhüllungselement 22 an.

Der Piezoaktuator 13 umfasst ferner eine erste Kappe 28, die in einem ersten Bereich 30 mit einer Rohrfeder 26 verschweißt ist. Ferner ist eine zweite Kappe 32 vorgesehen, die in einem zweiten Bereich 34 mit der Rohrfeder 26 verschweißt ist und so den Piezokörper 14 mit einer vorgegebenen Vorspannkraft vorspannt.

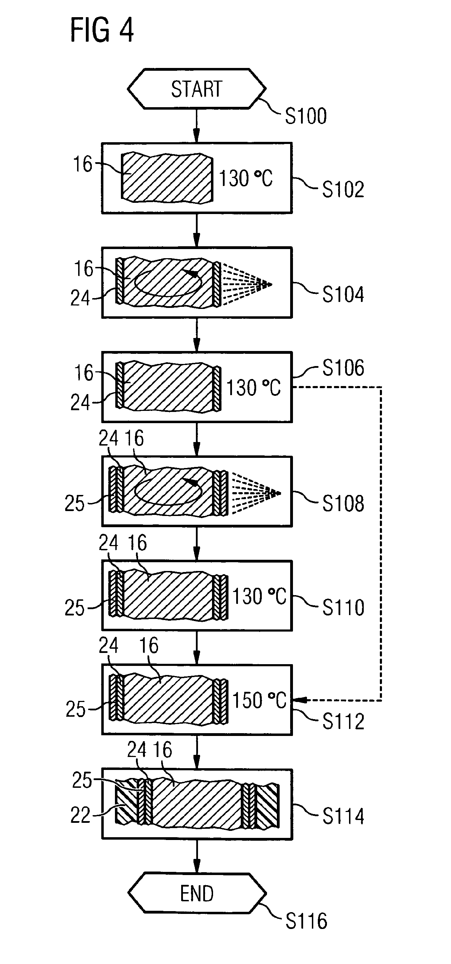

Ein in Figur 4 schematisch dargestelltes Programm zur Steuerung einer Vorrichtung zur Herstellung des Piezokörpers 14 ist vorzugsweise in einer Steuereinheit gespeichert.

Das Programm wird vorzugsweise in einem Schritt S100 gestartet, in dem gegebenenfalls Variablen initialisiert werden. Dies geschieht vorzugsweise zu Beginn des Verfahrens zur Herstellung des Piezokörpers 14.

In einem Schritt S102 wird der Stapel 16 piezoelektrischer Elemente vorzugsweise auf zirka 130°C erhitzt.

Die Bearbeitung des Programms wird anschließend in dem Schritt S104 fortgesetzt. In dem Schritt S104 wird ein erstes Silikon mit einem Haftvermittler auf den Stapel 16 piezoelektrischer Elemente aufgesprüht. Durch das Aufsprühen des ersten Silikons mit dem Haftvermittler auf den Stapel 16 piezoelektrischer Elemente wird die Isolierschicht 24 ausgebildet. Durch das Aufsprühen des ersten Silikons mit dem Haftvermittler auf den Stapel 16 piezoelektrischer Elemente kann die Haftung der Isolierschicht 24 an dem Stapel 16 piezoelektrischer Elemente sehr gut sichergestellt werden. Durch das vorhergehende Erhitzen des Stapels 16 piezoelektrischer Elemente auf vorzugsweise zirka 130°C kann erreicht werden, dass nach Aufsprühen des ersten Silikons eine Vernetzung der Isolierschicht 24 rasch einsetzen kann. Bevorzugt wird der Stapel 16 piezoelektrischer Elemente während des Aufsprühens des ersten Silikons in eine Rotationsbewegung versetzt. Damit kann die Isolierschicht 24 besonders gleichmäßig auf die Mantelfläche des Stapels 16 piezoelektrischer Elemente aufgetragen werden.

Anschließend wird die Bearbeitung des Programms in einem Schritt S106 fortgesetzt. In dem Schritt S106 wird der Stapel 16 piezoelektrischer Elemente mit der Isolierschicht 24 vorzugsweise auf zirka 130°C erhitzt. Es ist so ein rasches Vernetzen der Isolierschicht 24 und damit ein rasches anschließendes Aufbringen weiteren Schichten auf der Isolierschicht 24 möglich.

Die Bearbeitung des Programms kann anschließend in dem Schritt S108 fortgesetzt werden. In dem Schritt S108 wird das Silikon ohne Haftvermittler auf die Isolierschicht 24 aufgesprüht. Damit wird die Zwischenschicht 25 auf der Isolierschicht 24 ausgebildet. Durch die Ausbildung der Zwischenschicht 25 ohne Haftvermittler kann auch bei einem Einwirken von großen Kräften zwischen der Isolierschicht 24 und dem Umhüllungselement eine gute mechanische Entkopplung zwischen der Isolierschicht 24 und dem Umhüllungselement 22 erreicht werden. Bevorzugt rotiert der Stapel 16 piezoelektrischer Elemente während des Aufbringens des Silikons ohne Haftvermittler um seine Längsachse, so dass eine gleichmäßige Ausbildung der Zwischenschicht 25 auf der Isolierschicht 24 möglich ist. Die Bearbeitung des Programms wird anschließend in dem Schritt S110 fortgesetzt.

In dem Schritt S110 wird der Stapel 16 piezoelektrischer Elemente mit der Isolierschicht 24 und der Zwischenschicht 25 vorzugsweise auf zirka 130°C erhitzt. Es ist so ein rasches Vernetzen der Zwischenschicht 25 und damit eine mechanisch stabile Ausbildung der Zwischenschicht 25 möglich. Die Bearbeitung des Programms wird anschließend in dem Schritt S112 fortgesetzt.

Alternativ können die Schritte S108 und S110 übersprungen werden und die Bearbeitung des Programms nach Ausführung des Schritts S106 in dem Schritt S112 fortgesetzt werden (Fig. 4, gestrichelte Linie).

In dem Schritt S112 wird der Stapel 16 piezoelektrischer Elemente mit der Isolierschicht 24 und gegebenenfalls der Zwischenschicht 25 vorzugsweise über eine Zeitraum von 15 Stunden auf zirka 150°C erhitzt. Damit können gegebenenfalls in der Isolierschicht 24 und der Zwischenschicht 25 vorliegende Gase aus der Isolierschicht 24 und der Zwischenschicht 25 ausgetrieben werden und so eine besonders stabile Ausbildung der Isolierschicht 24 und der Zwischenschicht 25 erreicht werden.

Die Bearbeitung des Programms wird anschließend in dem Schritt S114 fortgesetzt. In dem Schritt S114 wird ein weiteres Silikon auf die Zwischenschicht 25 oder gegebenenfalls die Isolierschicht 24 mittels Spritzgießen aufgetragen. Dadurch wird ein Umhüllungselement 22 ausgebildet, das mindestens einen Teil des Stapels 16 piezoelektrischer Elemente umhüllt. Damit können die Kontaktstifte 18 und die Kontaktdrähte 20 zum Herstellen elektrischer Verbindungen zu den piezoelektrischen Elementen in dem Umhüllungselement 22 eingebettet sein. Des Weiteren ermöglicht das Umhüllungselement 22 eine elektrische Isolation des Piezokörpers 14 gegenüber dem Gehäuse 1 zur Aufnahme des Piezokörpers 14. Die Bearbeitung wird nun in einem Schritt S116 fortgesetzt.

In dem Schritt S116 wird das Programm beendet.

## Patentansprüche

1. Verfahren zur Herstellung eines Piezokörpers (14), wobei der Piezokörper (14) aufweist einen Stapel (16) piezoelektrischer Elemente,
mit folgenden Schritten:
- Aufsprühen eines ersten Silikons mit einem Haftvermittler auf den Stapel (16) piezoelektrischer Elemente zum Herstellen einer Isolierschicht (24), und
- Aufbringen eines weiteren Silikons mittels Spritzgießen zum Herstellen eines Umhüllungselements (22), das zum Umhüllen mindestens eines Teils des Stapels (16) piezoelektrischer Elemente ausgebildet ist.

2. Verfahren nach Anspruch 1, bei dem nach dem Herstellen der Isolierschicht (24) und vor dem Aufbringen des weiteren Silikons ein Silikon ohne Haftvermittler auf die Isolierschicht (24) aufgesprüht wird zum Herstellen einer Zwischenschicht (25).

3. Verfahren nach einem der vorhergehenden Ansprüche, bei dem vor dem Aufbringen des ersten Silikons mit dem Haftvermittler auf den Stapel (16) piezoelektrischer Elemente der Stapel (16) piezoelektrischer Elemente erhitzt wird.

4. Verfahren nach einem der vorhergehenden Ansprüche, bei dem der Stapel (16) piezoelektrischer Elemente während des Aufbringens des ersten Silikons und/oder des Silikons ohne Haftvermittler eine Rotationsbewegung ausführt.

5. Vorrichtung zur Herstellung eines Piezokörpers (14), wobei der Piezokörper (14) aufweist einen Stapel (16) piezoelektrischer Elemente, wobei die Vorrichtung ausgebildet ist zum:
- Aufsprühen eines ersten Silikons mit einem Haftvermittler auf den Stapel (16) piezoelektrischer Elemente zum Herstellen einer Isolierschicht (24), und
- Aufbringen eines weiteren Silikons mittels Spritzgießen zum Herstellen eines Umhüllungselements (22), das zum Umhüllen mindestens eines Teils des Stapels (16) piezoelektrischer Elemente ausgebildet ist.

## Claims

1. Method for producing a piezoelectric body (14), wherein the piezoelectric body (14) has a stack (16) of piezoelectric elements,
having the following steps of:
- spraying a first silicone with a bonding agent onto the stack (16) of piezoelectric elements in order to produce an insulating layer (24), and
- applying a further silicone by means of injection-moulding in order to produce an enveloping element (22) which is designed to envelop at least a part of the stack (16) of piezoelectric elements.

2. Method according to Claim 1, wherein, after the production of the insulating layer (24) and prior to the application of the further silicone, a silicone without bonding agent is sprayed onto the insulating layer (24) in order to produce an intermediate layer (25).

3. Method according to either of the preceding claims, wherein, prior to the application of the first silicone with the bonding agent onto the stack (16) of piezoelectric elements, the stack (16) of piezoelectric elements is heated.

4. Method according to one of the preceding claims, wherein the stack (16) of piezoelectric elements performs a rotary movement during the application of the first silicone and/or the silicone without bonding agent.

5. Apparatus for producing a piezoelectric body (14), wherein the piezoelectric body (14) has a stack (16) of piezoelectric elements, wherein the apparatus is designed to:
- spray a first silicone with a bonding agent onto the stack (16) of piezoelectric elements in order to produce an insulating layer (24), and
- apply a further silicone by means of injection-moulding in order to produce an enveloping element (22) which is designed to envelop at least a part of the stack (16) of piezoelectric elements.

## Revendications

1. Procédé de fabrication d'un corps piézo-électrique (14), dans lequel le corps piézo-électrique (14) présente un empilement (16) d'éléments piézo-électriques,
avec les étapes suivantes :
- pulvérisation d'une première silicone avec un avec promoteur d'adhérence sur l'empilement (16) d'éléments piézo-électriques pour la réalisation d'une couche d'isolation (24), et
- application d'une silicone supplémentaire au moyen d'un moulage par injection pour la réalisation d'un élément d'enrobage (22) conçu pour enrober au moins une partie de l'empilement (16) d'éléments piézo-électriques.

2. Procédé selon la revendication 1, dans lequel, après la réalisation de la couche d'isolation (24) et avant l'application de la silicone supplémentaire, une silicone sans promoteur d'adhérence est pulvérisée sur la couche d'isolation (24) pour la réalisation d'une couche intermédiaire (25).

3. Procédé selon l'une des revendications précédentes, dans lequel, avant l'application de la première silicone avec le promoteur d'adhérence sur l'empilement (16) d'éléments piézo-électriques, l'empilement (16) d'éléments piézo-électriques est chauffé.

4. Procédé selon l'une des revendications précédentes, dans lequel l'empilement (16) d'éléments piézo-électriques effectue un mouvement de rotation pendant l'application de la première silicone et/ou de la silicone sans promoteur d'adhérence.

5. Dispositif de fabrication d'un corps piézo-électrique (14), dans lequel le corps piézo-électrique (14) présente un empilement (16) d'éléments piézo-électriques, dans lequel le dispositif est conçu pour :
- pulvériser une première silicone avec un promoteur d'adhérence sur l'empilement (16) d'éléments piézo-électriques pour la réalisation d'une couche d'isolation (24), et
- appliquer une silicone supplémentaire au moyen d'un moulage par injection pour la réalisation d'un élément d'enrobage (22) conçu pour enrober au moins une partie de l'empilement (16) d'éléments piézo-électriques.
